# EUROPEAN PATENT APPLICATION

(11) **EP 1 589 799 A1**
(43) Date of publication of application: **26.10.2005**
(21) Application number: 04703471.5
(22) Date of filing: 20.01.2004
(51) Int. Cl.: H05K 3/46, H01L 23/12

(54) **MULTI-LAYER CERAMIC SUBSTRATE AND METHOD FOR MANUFACTURE THEREOF**

(30) Priority: 21.01.2003 JP 2003012384
(71) Applicant: TDK Corporation, Tokyo 103-8272 (JP)
(72) Inventor: HATANAKA, Kiyoshi c/o TDK Corporation, Tokyo 1038272 (JP); NINOMIYA, Hideaki c/o TDK Corporation, Tokyo 1038272 (JP); NISHINO, Haruo c/o TDK Corporation, Tokyo 1038272 (JP); TAKAHASHI, Takeshi c/o TDK Corporation, Tokyo 1038272 (JP)
(74) Representative: Vossius & Partner
(86) International application number: PCT/JP2004/000399
(87) International publication number: WO 2004/066699

(57) **Abstract**

A plurality of first green sheets forming first ceramic layers after firing are stacked to form a first pre-fired substrate 4. Next, a plurality of second green sheets forming second ceramic layers after firing are stacked to form a second pre-fired substrate. Next, the first pre-fired substrate 4 is formed with recesses 10. Next, first pre-fired blocks 6 of sizes fitting into the recesses are formed from the second pre-fired substrate. The first pre-fired blocks 6 are fit into the recesses 10 so that the stacking direction A of the first green sheets and the stacking direction A' of the second green sheets become the same. The first pre-fired substrate 4 in which the first pre-fired blocks 6 are fit is fired.

## Description

The present invention relates a multilayer ceramic substrate comprised of a combination of a plurality of ceramic materials having mutually different electrical characteristics and/or physical characteristics and a method of production of the same.

A multilayer ceramic substrate is comprised of a plurality of ceramic layers. The ceramic layers have formed between them, following along their interfaces, interconnect conductors. Usually, a multilayer ceramic substrate is made multifunctional and sophisticated in performance by producing it by stacking green sheets of a plurality of types of ceramic materials having mutually different electrical characteristics or physical characteristics and simultaneously firing the obtained composite stack. This is for building into the multilayer ceramic substrate capacitors, inductors, and other electronic devices requiring different dielectric constant characteristics etc.

However, if stacking and simultaneously firing green sheets of a plurality of types of ceramic materials having mutually different electrical characteristics or physical characteristics, the differences in shrinkage behavior of the green sheets of the different ceramic materials etc. will cause cracking or peeling in some cases.

To resolve this problem, for example, JP-A-2001-144438(Patent Document 1)proposes a multilayer ceramic substrate comprised of dielectric ceramic materials having mutually different dielectric constants stacked together, wherein interdiffusion between layers and shrinkage of the multilayer ceramic substrate are prevented by the method of providing shrinkage suppressing green sheets between the layers.

However, in the method described in Patent Document 1, the thicknesses of the shrinkage suppressing green sheets themselves are added on. On top of this, to form devices complying with the dielectric constants in the principal plane directions of the layers, sufficient thicknesses of the layers have to be secured. For this reason, the thickness of the multilayer ceramic substrate as a whole increases. This runs counter to the demands for increasing compactness of electronic equipment.

JP-A-11-163530(Patent Document 2)discloses technology forming a space inside a stack of pre-fired green sheets, fitting into that space a pre-fired shaped article block, then simultaneously firing the shaped article block and stack of green sheets.

However, the technology described in Patent Document 2 has the stacking direction of the stack forming the pre-fired shaped article block substantially perpendicular to the stacking direction of the green sheets in which this shaped article block is inserted. Consequently, there is the problem that at the time of firing, the shaped article block easily detaches from the stack of the green sheets. For this reason, in the technology described in Patent Document 2, it is necessary to insert the shaped article block into the stack of the green sheets, then sandwich this by non-shrinkable sheet-shaped supports not being fired at the firing temperature of the green sheets so as to fire the stack of the green sheets.

The present invention was made in consideration of this actual situation and has as its object the provision of a multilayer ceramic substrate where the different layers do not have any effect on each other, the thickness of the multilayer ceramic substrate as a whole is sharply suppressed, and formation of devices is facilitated.

To achieve the above object, the method of production of a multilayer ceramic substrate according to the present invention comprises the steps of:
stacking a plurality of first green sheets forming first ceramic layers after firing so as to form a first pre-fired substrate,
stacking a plurality of second green sheets forming second ceramic layers after firing so as to form a second pre-fired substrate,
forming a recess in said first pre-fired substrate,
forming from said second pre-fired substrate a first pre-fired block of a size fitting in said recess,
fitting said first pre-fired block into said recess so that a stacking direction of said first green sheets and a stacking direction of said second green sheets become the same, and
firing said first pre-fired substrate in which said first pre-fired block is fit.

In the method of production of a multilayer ceramic substrate according to the present invention, first pre-fired substrate at the side to be fit into and the first pre-fired block at the side for fitting into it are respectively formed by stacking green sheets of the same materials, so there is little peeling between layers or cracking at the time of firing. Further, since the stack of the first ceramic layers and the stack of the second ceramic layers with mutually different dielectric constants are positioned respectively independently in the substrate and sufficient thicknesses are secured, it is possible to form electronic devices matching those dielectric constants.

For example, a location having a relatively large dielectric constant (block or substrate) may be formed with capacitor devices, while a location having a relatively small dielectric constant (block or substrate) may be formed with inductor devices etc., i.e., the freedom of design is secured. Further, even if the shrinkages of the substrate materials differ somewhat at the time of firing, since the stacking direction of the block and the stacking direction of the substrate are the same, the tendencies for shrinkage are also the same and therefore the fired block will not detach from the fired substrate. Further, since interconnects formed on the surface of the substrate are used to connect the members, this as well means that the fired block will not detach from the fired substrate.

Preferably, said first pre-fired block is not formed with terminals at its side faces and said first pre-fired block is formed with terminals at its top surface and/or bottom surface. Since the block is not formed with terminals at its side faces, there is no need for connection with the substrate at the side faces of the block. Further, at the top surface and/or bottom surface of the block, it is possible to connect with surface electrodes of the substrate through the terminals. Further, since the block is not formed with terminals at its side faces, there are no internal conductor layers present near the side faces of the block and therefore there is no problem even if differences in materials between the block and substrate etc. cause a reaction to occur at the side faces of the block at the time of firing.

Preferably, said recess is a through hole passing through said first pre-fired substrate from a top surface to a bottom surface. Said through hole may have fit into it together with said first pre-fired block a second pre-fired block different from said first pre-fired block. Alternatively, said recess may be a closed-end hole not passing through said first pre-fired substrate from a top surface to a bottom surface. The depth and structure of the recess may be freely designed in accordance with the size, number, etc. of the devices to be built into the block. Further, by fitting inside the recess the other second pre-fired block, it is possible to house blocks having different dielectric constants inside the same recess.

Preferably, said first green sheets and second green sheets are comprised of materials giving different dielectric constants after firing. Alternatively, the first green sheets and second green sheets are comprised of the same material but made different in thickness. Preferably, the thicknesses of said first green sheets forming said first pre-fired substrate are greater than the thicknesses of said second green sheets. For example, the thicknesses of the second green sheets forming the block in which devices are to be built are preferably thin from the viewpoints of reducing the size and raising the performance of the devices. Further, the thicknesses of the first green sheets in which devices are not to be built, but where simple interconnect layers etc. are to be built are preferably greater from the viewpoint of reducing the stacking step.

Preferably, said first green sheets and/or said second green sheets have internal conductor layers interposed between them. These internal conductor layers form interconnect layers or internal electrodes of built in devices etc.
Preferably, said first green sheets and said second green sheets have the same extents of press shrinkage and firing shrinkage. In this case, when pressing or firing the first pre-fired substrate in which the first pre-fired block is fit, peeling between the block and substrate or cracks etc. can be more effectively suppressed.

In the present invention, it is preferable to fit said first pre-fired block into the recess of said first pre-fired substrate, then fire said first pre-fired substrate and connect the terminals formed at the surface of the fired substrate and the terminals formed at the surface of the fired block by interconnects.
Alternatively, it is possible to fit said first pre-fired block into the recess of said first pre-fired substrate, then connect the terminals formed at the surface of the first pre-fired block and the terminals formed at the surface of said first pre-fired substrate by interconnects, then fire said first pre-fired substrate.

The multilayer ceramic substrate of the present invention is produced by any of the above methods of production. Note that the multilayer ceramic substrate according to the present invention may be used alone as a finished product or the multilayer ceramic substrate may have other electronic devices attached to it.

Below, the present invention will be explained based on embodiments shown in the drawings.
FIG. 1 is a schematic cross-sectional view showing a step of production of a multilayer ceramic substrate according to an embodiment of the present invention,
FIG. 2 is a schematic cross-sectional view showing a step after FIG. 1,
FIG. 3 is a schematic cross-sectional view of a first pre-fired block shown in FIG. 1,
FIG. 4 is a plan view of the first pre-fired block shown in FIG. 3,
FIG. 5 is a plan view of state after printing the surface of the fired substrate with circuit patterns and connecting the terminals of the block and terminals of the substrate to predetermined patterns,
FIG. 6A and FIG. 6B are schematic cross-sectional views of multilayer ceramic substrates according to other embodiments of the present invention.
embodiment

### First Pre-fired Substrate

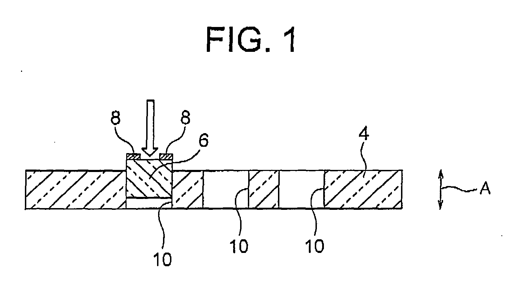

As shown in FIG. 1, in the method of production of a multilayer ceramic substrate according to one embodiment of the present invention, first a first pre-fired substrate 4 is prepared. The first pre-fired substrate 4 is produced by stacking a plurality of first green sheets forming a first ceramic layer after firing in a thickness direction A, then temporarily press bonding this in the stacking direction A. The first green sheets are, in accordance with need, formed with internal conductor layers between them.

When stacking the first green sheets and internal conductor layers, if using the printing method, it is sufficient to print successive layers of dielectric paste and the internal conductor paste on a polyethylene terephthalate or other substrate. Further, if using the sheet method, it is sufficient to use dielectric paste to form green sheets, printing these with the internal conductor paste, then stack these.

The thickness of the first pre-fired substrate 4 is not particularly limited, but for example is 0.4 mm to 1.5 mm or so. The shape of the first pre-fired substrate 4 is not particularly limited, but in this embodiment, is a square shape of 25 mm x 25 mm. The pressure of the temporary press bonding is not particularly limited, but preferably is 3 to 8 MPa or so. The heating temperature at that time is 50 to 100°C or so.

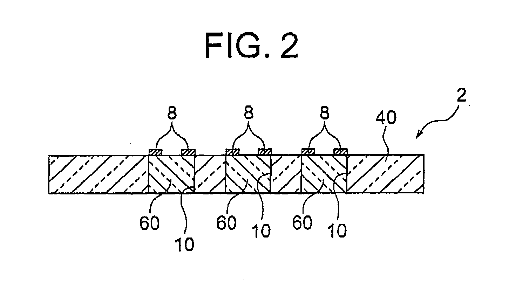

The thickness of the individual first green sheets is determined by the devices, interconnects, etc. to be built into the first substrate 40 shown in FIG. 2 obtained by firing the first pre-fired substrate 4 or other applications and generally is 20 to 245 µm or so. For example, in the case of an application where it is desired to build a large number of inductors into the first substrate 40, the thickness of the first green sheets is preferably made small. Further, in the case of forming high Q-value interconnects in the first substrate 40 or in the case of forming heat dissipating via holes etc., the first green sheets are preferably made thick. The number of the first green sheets stacked is not particularly limited, but is 4 to 50 or so.

The first green sheets are fabricated from dielectric paste. The dielectric paste is comprised of a dielectric material and an organic vehicle kneaded together and may be an organic-based coating or a water-based coating.

The dielectric material used is one which forms a main ingredient and sub ingredient in accordance with the ingredients of the dielectric ceramic composition. Note that the form of the materials is not particularly limited. Oxides forming the main ingredients and sub ingredients and/or compounds giving these oxides upon firing are used. These materials may be powder obtained by liquid-phase synthesis, the solid-phase method, etc.

Note that as compounds giving oxides upon firing, for example, carbonates, nitrates, oxalates, organometallic compounds, etc. may be mentioned by way of illustration. Of course, oxides may also be used together with compounds giving oxides upon firing. The contents of the compounds in the dielectric material should be determined so as to give the ingredients of the dielectric composition explained above after firing.

The "organic vehicle" means a binder dissolved in an organic solvent. The binder used for the organic vehicle is not particularly limited, but ethyl cellulose, polyvinyl butyral, or other usual types of binders may be suitably selected from. Further, the organic solvent used at this time is also not limited. Terpineol, butyl carbitol, acetone, toluene, or other organic solvents may be suitably selected from in accordance with the printing method, sheet method, or other method used.

Further, the "water-soluble coating" means a water-soluble binder, dispersant, etc. dissolved in water, while the "water-soluble binder" is not particularly limited and may be suitably selected from polyvinyl alcohol, cellulose, water-soluble acrylic resin, emulsion, etc.

The internal conductor paste is prepared by kneading conductive materials comprised of the above-mentioned various types of conductive metals or alloys or various types of oxides giving the above-mentioned conductive materials after firing, organometallic compounds, resinates, etc. and the above-mentioned organic vehicle.

The content of the organic vehicle of each of the above-mentioned pastes is not particularly limited and may be an ordinary content, for example, it may include the binder in an amount of 1 to 5 wt% or so and the solvent in an amount of 10 to 50 wt% or so. Further, each paste may contain, in accordance with need, additives selected from various types of dispersants, plasticizers, dielectrics, insulator, etc.

### Second Pre-fired Substrate and First Pre-fired Block

Next, the second pre-fired substrate is prepared. The size and thickness of the second pre-fired substrate is the same as the first pre-fired substrate 4. The method of making the second pre-fired substrate is also similar to that of the first pre-fired substrate 4. However, in the present embodiment, the dielectric material of the second green sheets forming the second pre-fired substrate or the sheet thicknesses are made different from those of the first green sheets forming the first pre-fired substrate 4. Further, the second green sheets have formed between them, for example, inductor devices, capacitor devices, LC complex circuit devices, filter circuit devices, and other devices and patterns for making interconnects among these devices.

Note that preferably the dielectric material included in the dielectric paste forming the second green sheets can be fired at the same temperature as the dielectric material included in the dielectric paste forming the first green sheets and has the same extent of press shrinkage and firing shrinkage. As combinations satisfying these characteristics, for example, the combinations of the following compositions of materials may be mentioned by way of illustration.

For example, when the composition of the dielectric material of the first green sheets is an aluminum oxide-based dielectric material (SiO₂ in 26.45 wt%, B₂O₃ 1.76 wt%, Al₂O₃ 55.37 wt%, MgO 0.86 wt%, CaO 1.59 wt%, and SrO 13.97 wt%), the composition of the dielectric material of the second green sheets may be the compositions as shown next, that is, an aluminum oxide-titanium oxide-based dielectric material (SiO₂ in 32.62 wt%, B₂O₃ 2.18 wt%, Al₂O₃ 25.35 wt%, MgO 1.06 wt%, CaO 1.97 wt%, SrO 17.23 wt%, and TiO₂ 19.60 wt%), an aluminum oxide-titanium oxide-strontium oxide-based dielectric material (SiO₂ in 9.05 wt%, Al₂O₃ 9.21 wt%, La₂O₃ 19.63 wt%, B₂O₃ 2.21 wt%, BaO 8.79 wt%, TiO₂ 23.42 wt%, Bi₂O₃ 4.56 wt%, Nd₂O₅ 20.61 wt%, and Sro 1.73 wt%), a strontium felds par-α-quartz-based dielectric material (SiO₂ in 66.60 wt%, B₂O₃ 12.71 wt%, Al₂O₃ 9.20 wt%, Sb₂O₃ 5.33 wt%, CaO 1.61 wt%, SrO 3.12 wt%, ZnO 0.81 wt%, and MgO 0.56 wt%), an aluminum oxide-α-quartz-based dielectric material (BaO in 24.59 wt%, Al₂O₃ 19.05 wt%, SiO₂ 53.94 wt%, and B₂O₃ 2.42 wt%) , an osmium oxide-titanium oxide-based dielectric material (BaO in 20.21 wt%, Nd₂O₃ 36.81 wt%, TiO₂ 37.73 wt%, B₂O₃ 1.42 wt%, CuO 0.95 wt%, and ZnO 1.90 wt%), etc. are preferable.

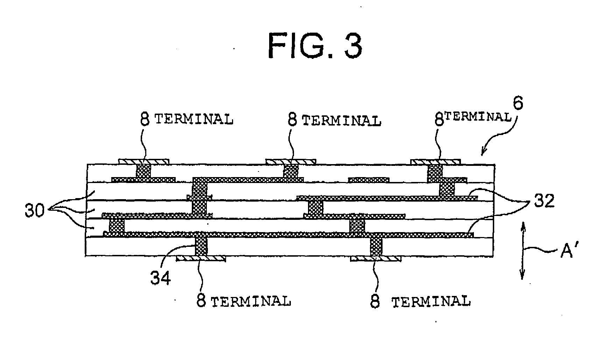

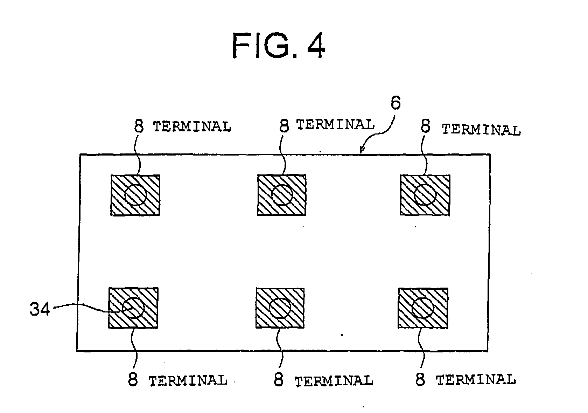

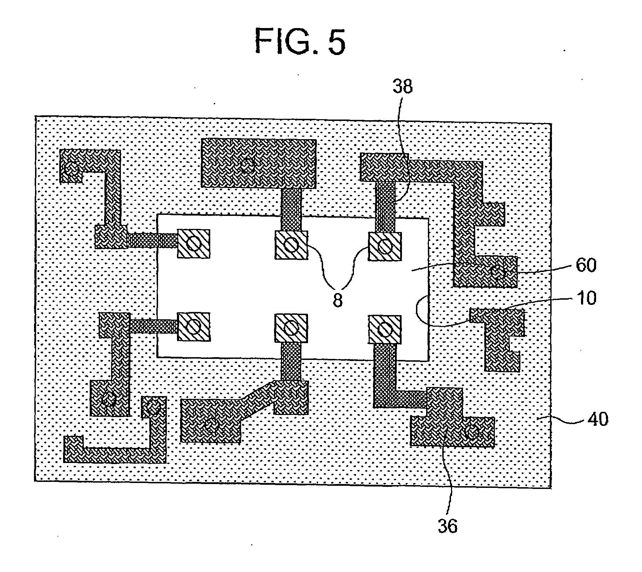

After the second pre-fired substrate is prepared, next this second pre-fired substrate is cut or punched to predetermined sizes to obtain the first pre-fired blocks 6 shown in FIG. 1. The first pre-fired blocks 6 are not particularly limited, but for example are sizes of 1 mm to 10 mm square. The thicknesses are the same as the thickness of the first pre-fired substrate 4. Note that the top surfaces and/or back surfaces of the first pre-fired blocks 6, as shown in FIG. 3 and FIG. 4, are formed with terminals 8. The terminals 8 are formed by printing etc. external terminal paste the same as the internal conductor paste. The terminals 8 may be formed at the stage of the second pre-fired substrate or may be formed at the stage of the blocks. As shown in FIG. 5, the top surface and/or bottom surface of the first pre-fired substrate 4 is also formed with terminals 36. These terminals 36 are in a later step connected by interconnects 38 to predetermined circuit patterns.

### Formation of Recess, Fitting, and Firing

Separate from the steps for fabricating the first pre-fired blocks 6 from the second pre-fired substrate, the first pre-fired substrate 4 is formed with through holes (recesses) 10 passing through it from the top to bottom surface by for example punching. The through holes 10 are slightly larger in size than the size of the first pre-fired blocks 6. As shown in FIG. 1, each through hole 10 is fit with a corresponding first pre-fired block 6. The top surfaces and bottom surfaces of the first pre-fired blocks 6 are substantially planar with the top surface and bottom surface of the first pre-fired substrate 4.
Note that, as shown in FIG. 3, each first pre-fired block 6 is comprised of a plurality of green sheets 30 stacked in the thickness direction A'. The layers of the green sheets 30 have internal electrode layers 32 interposed between them in predetermined patterns. These internal electrode layers 32 and terminals 8 are connected by via holes 34 etc. In this embodiment, the first pre-fired blocks 6 are fit in the through holes 10 so that the stacking direction A' of the green sheets 30 of the first pre-fired blocks 6 becomes same as the stacking direction A of the green sheets in the first pre-fired substrate 4 shown in FIG. 1.

After this, the first pre-fired substrate 4 in which the first pre-fired blocks 6 are fit is pressed in the stacking direction. The pressure is not particularly limited, but is preferably 40 to 100 MPa or so. The heating temperature is about 35 to 80°C or so. After this, the first pre-fired substrate 4 is treated to remove the binder and fired together with the first pre-fired blocks 6 whereby the multilayer ceramic substrate 2 comprised of the fired first substrate 40 and blocks 60 shown in FIG. 2 is obtained.

The firing temperature is determined by the material of the green sheets etc. and is not particularly limited, but in general is 850 to 1000°C. Further, the firing atmosphere may be suitably determined in accordance with the type of the conductive material in the internal conductor paste. When using as the conductive material Ni or an Ni alloy or other base metal, a reducing atmosphere is preferable. The oxygen partial pressure of the firing atmosphere is preferably 10⁻¹⁰ to 10⁻³ Pa, more preferably 10⁻⁷ to 10⁻³ Pa. If the oxygen partial pressure at the time of firing is too low, the conductive material of the internal electrodes will be liable to be abnormally sintered and to break, while if the oxygen partial pressure is too high, the internal electrodes will tend to be oxidized.

After this, as shown in FIG. 5, the first substrate 40 is printed on its surface with circuit patterns, and the terminals 8 of the blocks 60 and the terminals 36 of the first substrate 40 are connected by interconnects 38 to predetermined patterns. Note that the circuit patterns may be printed before firing the first substrate 40 as well.

In the method of production of the multilayer ceramic substrate 2 according to the present embodiment, since the first pre-fired substrate 4 at the side to be fit in and the first pre-fired blocks 6 at the side to fit into it are comprised of green sheets of the same materials stacked together, at the time of firing, there is little peeling of layers, cracks, etc. Further, since the stack of the first substrate 40 and the stack of the blocks 60 with the mutually different dielectric constants are positioned in the substrate independently and sufficient thicknesses can be secured, electronic devices matching with their dielectric constants can be formed.

For example, a location having a relatively large dielectric constant (block 60 or first substrate 40) may be formed with capacitor devices, while a location having a relatively small dielectric constant (block 60 or substrate 40) may be formed with inductor devices etc., i.e., the freedom of design is secured. Further, even if the shrinkages of the substrate materials differ somewhat at the time of firing, since the stacking direction A' of the first pre-fired blocks 6 and the stacking direction A of the first pre-fired substrate 4 are the same, the tendencies for shrinkage are also the same and therefore the fired blocks 60 will not detach from the fired first substrate 40. Further, since interconnects 38 formed on the surface of the first substrate 40 are used to connect the members, this as well means that the fired blocks 60 will not detach from the fired first substrate 40.

### Other Embodiments

Note that the present invention is not limited to the above-mentioned embodiment and may be modified in various ways within the scope of the present invention.

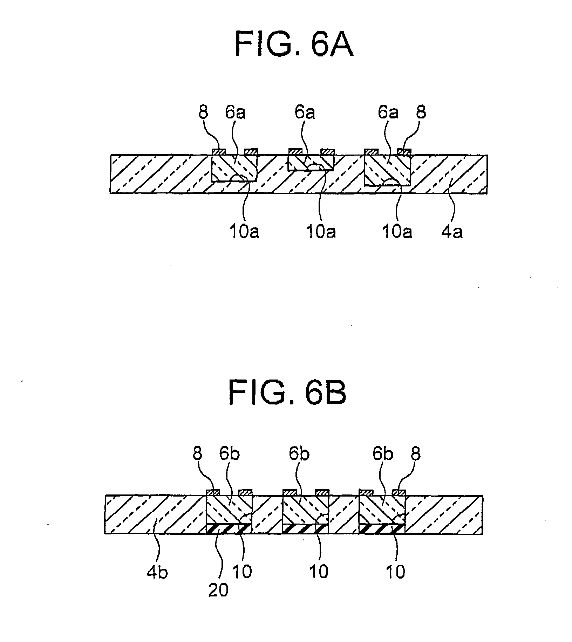

For example, as shown in FIG. 6A, the first pre-fired substrate 4a may be formed in its surface with closed end holes 10a of different depths not passing through the substrate from its top to bottom surfaces. First pre-fired blocks 6a matching the sizes of the closed end holes 10a may be fit into them. The top surfaces of the first pre-fired blocks 6a are substantially planar with the surface of the first pre-fired substrate 4a. The rest of the steps are similar to those of the embodiment shown in FIG. 1 to FIG. 5.

This embodiment exhibits actions and effects similar to those of the embodiment shown in FIG. 1 to FIG. 5. Further, since first pre-fired blocks 6a having dielectric constants and other electrical characteristics different from those of the first pre-fired substrate 4a are built into the substrate at the minimum necessary parts of the multilayer ceramic substrate, the freedom of design is further increased and the substrate is made compacter.

Further, in the present invention, as shown in FIG. 6B, the first pre-fired substrate 4b may also be formed with a plurality of through holes 10 and at least some of the through holes 10 may be fit, together with the first pre-fired blocks 6b, with other second pre-fired blocks 20. The second pre-fired blocks 20, for example, are blocks having different dielectric constants or other electrical characteristics from the first pre-fired blocks 6b or blocks comprised of green sheets of thicknesses different from the thicknesses of the green sheets forming the first pre-fired blocks 6b. The rest of the steps are similar to those of the embodiment shown in FIG. 1 to FIG. 5.

This embodiment exhibits actions and effects similar to those of the embodiment shown in FIG. 1 to FIG. 5. Further, since blocks 6b and 20 having dielectric constants and other electrical characteristics different from those of the first pre-fired substrate 4b can be built into the substrate, the freedom of design is further increased and the substrate is made compacter.

Further, in the present invention, the pre-fired substrates 4, 4a, and 4b in which these blocks 6, 6a, 6b, and 20 are embedded may also be stacked as is, without firing, with other pre-fired substrates and then fired.

As explained above, according to the present invention, it is possible to provide a multilayer ceramic substrate where the different layers do not have any effect on each other, the thickness of the multilayer ceramic substrate as a whole is sharply suppressed, and formation of devices is facilitated. Further, in the present invention, since the stacking direction of the green sheets in the fit blocks and the stacking direction of the green sheets in the substrate into which the blocks are fit are the same, there is no need for non-shrinkable sheet-shaped supports at the time of firing and the blocks can be made integral with the substrate so as not to detach after firing.

## Claims

1. A method of production of a multilayer ceramic substrate comprising the steps of:
stacking a plurality of first green sheets forming first ceramic layers after firing so as to form a first pre-fired substrate,
stacking a plurality of second green sheets forming second ceramic layers after firing so as to form a second pre-fired substrate,
forming a recess in said first pre-fired substrate,
forming from said second pre-fired substrate a first pre-fired block of a size fitting in said recess,
fitting said first pre-fired block into said recess so that a stacking direction of said first green sheets and a stacking direction of said second green sheets become the same, and
firing said first pre-fired substrate in which said first pre-fired block is fit.

2. The method of production of a multilayer ceramic substrate as set forth in claim 1, wherein said first pre-fired block is not formed with terminals at its side faces and said first pre-fired block is formed with terminals at its top surface and/or bottom surface.

3. The method of production of a multilayer ceramic substrate as set forth in claim 1 or 2, wherein said recess is a through hole passing through said first pre-fired substrate from a top surface to a bottom surface.

4. The method of production of a multilayer ceramic substrate as set forth in claim 3, wherein said through hole fits said first pre-fired block and a second pre-fired block different from said first pre-fired block.

5. The method of production of a multilayer ceramic substrate as set forth in claim 1 or 2, wherein said recess is a closed-end hole not passing through said first pre-fired substrate from a top surface to a bottom surface.

6. The method of production of a multilayer ceramic substrate as set forth in any one of claims 1 to 5, wherein said first green sheets and second green sheets are comprised of materials giving different dielectric constants after firing.

7. The method of production of a multilayer ceramic substrate as set forth in any one of claims 1 to 6, **characterized in that** said first green sheets and second green sheets are different in thicknesses.

8. The method of production of a multilayer ceramic substrate as set forth in claim 7, **characterized in that** the thicknesses of said first green sheets forming said first pre-fired substrate are greater than the thicknesses of said second green sheets.

9. The method of production of a multilayer ceramic substrate as set forth in any one of claims 1 to 8, wherein said first green sheets and/or said second green sheets have internal conductor layers interposed between them.

10. The method of production of a multilayer ceramic substrate as set forth in any one of claims 1 to 9, **characterized by** fitting said first pre-fired block into the recess of said first pre-fired substrate, then firing said first pre-fired substrate and connecting terminals formed on the surface of said fired substrate and terminals formed on the surface of the fired block by interconnects.

11. The method of production of a multilayer ceramic substrate as set forth in any one of claims 1 to 9, **characterized by** fitting said first pre-fired block into the recess of said first pre-fired substrate, then connecting terminals formed on the surface of said first pre-fired block and terminals formed on the surface of said first pre-fired substrate by interconnects, then firing said first pre-fired substrate.

12. The method of production of a multilayer ceramic substrate as set forth in any one of claims 1 to 11, wherein said first green sheets and said second green sheets have the same extents of press shrinkage and firing shrinkage.

13. The multilayer ceramic substrate obtained by a method of production as set forth in any one of claims 1 to 12.
